# EUROPEAN PATENT APPLICATION

(11) **EP 2 199 252 A1**
(43) Date of publication of application: **23.06.2010**
(21) Application number: 08022076.7
(22) Date of filing: 18.12.2008
(51) Int. Cl.: B81C 1/00

(54) **Method of making a micro electro mechanical system (MEMS) device**

(71) Applicant: Epcos AG, 81669 München (DE)
(72) Inventor: Zijlstra, Piebe Anne, 6587 AJ Middelaar (NL); Knotter, Dirk Marteen, 6537 TW Nijmegen (NL); van Weert, Jeroen, 6537 LK Nijmegen (NL); van Velzen, Bart, 6811 JE Arnhem (NL)
(74) Representative: Epping - Hermann - Fischer

(57) **Abstract**

A method of manufacturing a micro electro mechanical system (MEMS) device, comprising the steps of: providing a substrate, depositing an active layer, depositing a sacrificial layer, forming a MEMS structure in the active layer, wherein forming the MEMS structure comprises depositing a capping layer over the sacrificial layer, etching holes into the capping layer, removing the sacrificial layer with a dry etching process.

## Description

The invention relates to a method of manufacturing a micro electro mechanical system (MEMS) device, the method comprising a step of dry etching a sacrificial layer.

One of the critical steps in the production of MEMS is the making of crevices or tubes. This is done by etching a sacrificial layer and in general liquid chemicals are used for the etching process. The problem with wet etching is that the liquid is difficult to extract from the crevices. Further more during the removing of the dissolution the mechanical part can irreversible stick on a surface or can be damaged.

A micro electro mechanical system (MEMS) combines mechanical elements with electronic elements. A MEMS device comprises a very small micro machined movable part, which can be used as sensor or actuator for example. MEMS devices can be used for example as micro-accelerometers, micro-actuators or micro-sensors. Some MEMS devices comprise as movable part a first electrode which can be moved relative to a second electrode usually a fixed one.

One difficulty in the production of a MEMS device is the step where the mobile or movable part is formed. A common and most popular technique to form the mobile part is to use a sacrificial layer. A sacrificial layer is a layer which is formed as an intermediary inside a multilayer structure of the device during the production process and which is removed in a later step. By removing the sacrificial layer a cavity is formed inside of the device. The element or layer arranged next to the sacrificial layer in the multilayer structure can for example hover in the device or form a bridge or a membrane after removing the sacrificial layer. This mobile part can for example be fixed in the remaining MEMS device with one or two of its ends. This makes it possible that this element can move in horizontal or vertical direction.

Because of the very small dimension and structures of these micro-devices it is difficult to remove dissolutions of the sacrificial layer out of the micro-tubes inside of the device, because of adhesion or capillary forces.

One goal of the new method is to solve this problem.

The problem is solved by a method according to claim 1.

A method of manufacturing a micro electro mechanical system (MEMS) device, comprising the steps of: providing a substrate, depositing an active layer, depositing a sacrificial layer, forming a MEMS structure in the active layer, wherein forming the MEMS structure comprises
- depositing a capping layer over the sacrificial layer,
- etching holes into the capping layer,
- removing the sacrificial layer with a dry etching process.

On the provided substrate an active layer is deposited. On the active layer a sacrificial layer is deposited. In this active layer a MEMS structure is formed. In the finished device, this MEMS structure is the part being able to move. Preferably the MEMS structure comprises electrically conductive material. The forming of the MEMS structure comprises several steps. A capping layer is deposited over the sacrificial layer. Holes are etched into the capping layer. The positions and number of the holes are matched to the later etching process respectively. The sacrificial layer is removed by a dry etching process. After removing the sacrificial layer the MEMS structure is able to move in the device.

Contrary to the wet etching process the dry etching process can use a gas as active agent. Also the reaction products of etching process are usually gases which can easily be removed out of the micro-tubes. In the case of gaseous etchant and gaseous reaction products, there occur no problems like the adhesion or capillary powers detaining liquids from being removed. The active gas and the reaction products can be easily removed by applying vacuum for example or by flushing the device with air or an inert gas.

In a variant of the method the step of depositing a sacrificial layer comprises depositing an aluminium layer. For example the sacrificial layer can comprises Al. The sacrificial layer could comprise Al as only metal or as alloy. The concentration in which Al is comprised in the sacrificial layer can range up to 100%.

The method can additionally comprise the steps of:
- depositing an interlayer on the substrate,
- removing a part of the interlayer,
- depositing the active layer on the interlayer.

In this variant an interlayer is deposited on the substrate before the active layer. After depositing the interlayer on the substrate parts on the interlayer are removed. This could be done before or after the active layer is deposited on the interlayer. If the part of the interlayer is removed after depositing the active layer on the interlayer a first interspace is formed between the substrate and the active layer. It is also possible, that the part of the interlayer is removed together with the sacrificial layer in one step.

In a variant of the method the etch process is an isotropic etch process. The advantage of an isotropic etch process in view of an anisotropic etch process is that also parts of the layer which are to be etched can be processed and etched which can not be directly reached from outside of the device because of being shadowed by other parts against straight line processing. For example the inner tubes of a device can not be processed by an ion-beam and therefore not be etched by a beam of non-reactive ions in an anisotropic process.

In another variant of the method the etching process is a plasma etching process. Plasma etching is an isotropic variant of the preferred dry etching methods, it is a chemical dry etching method. The selectivity of this method to specifically etch the material which should be etched depends amongst others on the reactive gas which is chosen.

For generating the plasma a vacuum reactor can be filled with the active gas up to a pressure of some millibar. The gas is then ignited for example by an inductively or capacitively coupled high frequency or a microwave discharge. The frequency of operation of the power source can be from the kHz range up to some GHz. Through the excitation of the gas either charged ions or neutral atoms or radicals are formed, depending on the excitation and the used gas. These species are more chemically reactive than the normal unexcited gas.

In a variant of the method an active gas is used for the etching process comprising Cl. One problem in developing a dry etching process is to find an active gas which not only selective etches that material but also forms volatile products with the etched material. Cl is a very active etching species and can also form volatile products with a multitude of elements. Cl can be used as Cl₂ or as compound comprising Cl like BCl₃, SiCl₄ or in a mixture with other gases like Cl_{2/}He.

In one variant of the method the active gas is selected to be able to etch Al and Al₂O₃. This gas can be used for example when the Al-layer is coated by a natural Al₂O₃-filmand. Both layers should be etched with the same gas. For this variant for example BCl₃ can be used.

In another variant the active gas is selected to selectively etch Al against Al₂O₃. Here, the Al₂O₃-film has to be removed in a separate process step. This step for example can be a sputter process. The natural Al₂O₃-film can also be removed by applying plasma for a short time, for example H₂-plasma, onto the surface. The Al₂O₃, which is not exposed to the initial plasma, will remain in the device. This method has the advantage that the active gas differentiates during the etching process between Al and Al₂O₃, so that selectively Al can be etched. For this method for example Cl containing species or Cl₂ can be used.

In another variant of the method, a material comprising Al is used for the sacrificial layer. The material preferably comprises Al in an amount of more than 95 mol-%. Sacrificial layers comprising Al or Al-alloys have the advantage that there are much more stable in a mechanical and thermal view than sacrificial layers made of organic materials. An advantage compared to a sacrificial layer made of SiO₂ is that the selectivity in the etching step between Al and Si is significant better than that between SiO₂ and Si or Si₃N₄.

In case the sacrificial layer has a natural oxide layer comprising Al, this oxide layer could be removed in a separate step before etching the sacrificial layer.

If the sacrificial layer is passivated for exampled by an oxide layer, this passivation-layer can be removed by applying plasma onto the surface of the sacrificial layer before etching the sacrificial layer.

The MEMS device can be an oscillator, a capacitor or a sensor.

The figures serve solely for illustrating the invention and have therefore been elaborated only in a schematic fashion and are not true to scale. Identical or identically acting parts are designated by identical reference symbols.

Figure 1 schematically shows an apparatus for plasma etching

Figures 2a/b schematically show the cross-section of a MEMS oscillator

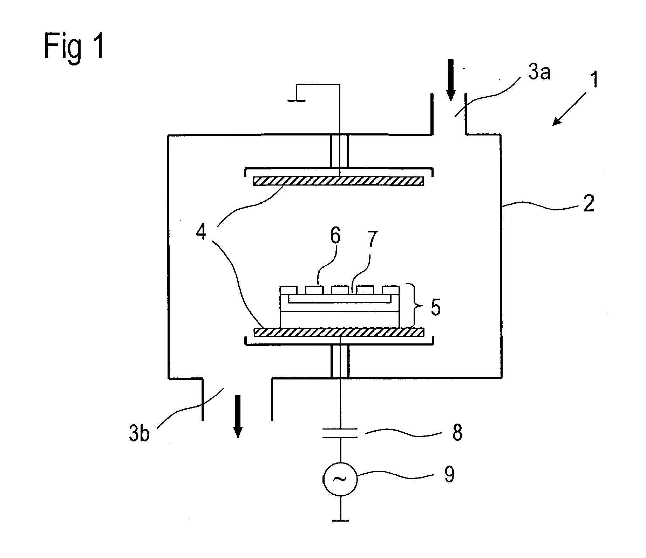

Figure 1 schematically shows an apparatus 1 which can be used for plasma etching. The apparatus 1 comprises a reaction chamber 2 with a gas inlet 3a and a gas outlet 3b. The pressure in the reaction chamber 2 can be reduced by evacuating the reaction chamber 2 over the gas outlet 3b before filling the reaction chamber 2 with the reactive gas over the gas inlet 3a. Before flushing the reaction chamber 2 with the reactive gas, the device 5 is deposited on one of the two electrodes 4. The two electrodes 4 are formed as two parallel plates. The electrode 4 onto which the device 5 is arranged is connected with a capacitor 8 and the capacitor 8 with a generator of high frequency 9. The device comprises a capping layer 6 and a sacrificial layer 7 under the capping layer. During the etching process the sacrificial layer 7 is removed. Through removing the sacrificial layer 7 a cavity is formed in the device 5.

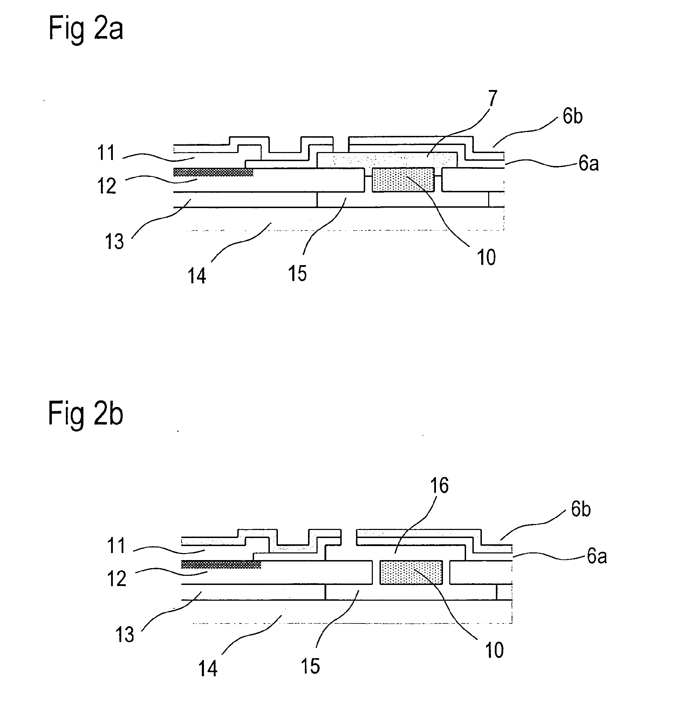

Figure 2a/b schematically shows a cross-section of a MEMS oscillator respectively. The oscillator comprises a substrate 14, which could be a Si-substrate for example. On the substrate 14 an insulating layer 13 is applied. The insulating layer 13 electrically insulates the substrate 14 from the rest of the device. The insulating layer 13 could be a SiO₂-layer for example. On the insulating layer 13 an active layer 12 is arranged. The active layer 12 can be a Si-layer. The three layers 12, 13 and 14 can be provided by a SOI-wafer (silicon-on-insulator-wafer). The active layer 12 of the wafer could be patterned and etched to form the oscillator 10 out of the active layer 12. The insulating layer 13 is partially removed to form a first interspace 15. In the finished device, the first interspace 15 allows the oscillator 10 to move downwards towards the substrate 14. A sacrificial layer 7 is applied onto the whole oscillator 10 and subareas of the active layer 12 (shown in figure 2a). If the deposition is done at low pressure, the pressure inside the interspace 15 is also very low. Al can be used for forming the sacrificial layer 7. The sacrificial layer 7 is removed later whereby the device shown in figure 2b is obtained. Removing the sacrificial layer 7 allows the oscillator 10 to move upwards too. A first protecting layer 6a is applied over the sacrificial layer 7. For the first protecting layer 6a a material is used, which is electrically isolating like and oxide or nitride. The first protecting layer 6a could be applied for example by PECVD (plasma enhanced chemical vapour deposition). A contact 11 is deposited on a subarea of the active layer 12 and on a small area of the first protecting layer 6a. The contact 11 can be used to contact the active layer 12 outside the oscillator 10. A metal or a low-ohmic polysilicon can be used for the contact 11. On the active surface of the device a second protection layer 6b is applied. This could be done by PECVD. An oxide or nitride could be used for the second protection layer 6b. Both layers 6a and 6b form the capping layer 6 previously mentioned.

The first and the second protection layer 6a/6b could be patterned in a way that a small area of the sacrificial layer 7 is exposed. Through the opening in the first and the second protection layer 6a/6b the sacrificial layer 7 can be removed like shown in figure 2b. By removing the sacrificial layer 7 a second interspace 16 is formed, which is located above the oscillator 10. The first and the second interspace 15/16 allow the oscillator 10 to move in the vertical direction.

With minor variations the MEMS device shown in figure 2b can be a capacitor or a sensor. In this case the movable part has to be made conductive and a second electrode has to be arranged distant from the movable part on top of the substrate or as part of the capping layer.

The above description of the invention using the exemplary embodiments is not to be understood to mean a restriction of the invention thereto. Rather, the inventive concept set out in claims 1 and 14 can be applied for a large number of very different designs. In particular, the invention also covers all combinations of the features cited in the exemplary embodiments and in the rest of the description, even if these combinations are not the subject matter of a patent claim.

### Reference

- 1: apparatus
- 2: reaction camber
- 3a: gas inlet
- 3b: gas outlet
- 4: electrode
- 5: device
- 6: capping layer
- 6a: first protecting layer
- 6b: second protecting layer
- 7: sacrificial layer
- 8: capacitor
- 9: high frequent generator
- 10: oscillator
- 11: contact
- 12: active layer
- 13: insulating layer
- 14: substrate
- 15: first interspace
- 16: second interspace

## Claims

1. A method of manufacturing a micro electro mechanical system (MEMS) device, comprising the steps of:
- providing a substrate (14),
- depositing an active layer (12),
- depositing a sacrificial layer (7),
- forming a MEMS structure in the active layer (12),
wherein forming the MEMS structure comprises
- depositing a capping layer (6) over the sacrificial layer (7),
- etching holes into the capping layer (6),
- removing the sacrificial layer (7) with a dry etching process.

2. A method of claim 1,
wherein the step of depositing a sacrificial layer (7) comprises depositing an aluminium layer.

3. A method of claim 1 or 2, comprising the steps of:
- depositing an interlayer (13) on the substrate (14),
- removing a part of the interlayer (13),
- depositing the active layer (12) on the interlayer (13).

4. The method of one of the foregoing claims,
wherein the dry etching process is an isotropic etching process.

5. The method of one of the foregoing claims,
wherein the etching process is a plasma etching process.

6. The method of one of the foregoing claims,
wherein an active gas comprising Cl is used for etching the sacrificial layer (7).

7. The method of claim 6,
wherein the active gas is selected to etch Al and Al₂O₃.

8. The method of claim 6,
wherein the active gas is selected to selectively etch Al against Al₂O₃.

9. The method of the foregoing claims,
wherein the material used for depositing the sacrificial layer (7) comprises Al in an amount of over 95 mol-%.

10. The method of claim 9,
wherein a natural oxide layer of the sacrificial layer (7) comprising Al is removed in a separate step before etching the sacrificial layer (7).

11. The method of one of the foregoing claims,
comprising the additional step of
- applying plasma onto the surface of said sacrificial layer (7) before etching said sacrificial layer (7).

12. The method of one of the foregoing claims,
wherein the micro electro mechanical system device is an oscillator.

13. The method of one of the foregoing claims,
wherein the micro electro mechanical system device is a capacitor.

14. The method of one of the foregoing claims,
wherein the micro electro mechanical system device is a sensor.
